(19) Europäisches Patentamt
European Patent Office
Office européen des brevets

(11) **EP 2 650 902 B1**

(12) **FASCICULE DE BREVET EUROPEEN**

(45) Date de publication et mention de la délivrance du brevet:
**13.11.2019 Bulletin 2019/46**

(21) Numéro de dépôt: **13163244.0**

(22) Date de dépôt: **11.04.2013**

(51) Int Cl.:
*H01J 37/22* *(2006.01)*   *H01J 37/317* *(2006.01)*

(54) **Procédé de correction des effets de proximité électronique utilisant des fonctions de diffusion de type voigt**

Verfahren zur Korrektur von elektronischen Proximityeffekten durch Verwendung dezentrierter Diffusionsfunktionen vom Typ Voigt

Method for correcting electronic proximity effects using Voigt scattering functions

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.04.2012 FR 1253389**

(43) Date de publication de la demande:
**16.10.2013 Bulletin 2013/42**

(73) Titulaire: **Aselta Nanographics**
**38000 Grenoble (FR)**

(72) Inventeurs:
• **Tortai, Jean-Hervé**
 **38000 Grenoble (FR)**
• **Schiavone, Patrick**
 **38190 Villard-Bonnot (FR)**
• **Figuerio, Thiago**
 **38000 Grenoble (FR)**
• **Jedidi, Nader**
 **38100 Grenoble (FR)**

(74) Mandataire: **Priori, Enrico et al**
**Marks & Clerk France**
**Immeuble "Visium"**
**22, avenue Aristide Briand**
**94117 Arcueil Cedex (FR)**

(56) Documents cités:
• **KIROV A S ET AL: "Towards two-dimensional brachytherapy dosimetry using plastic scintillator: localization of the scintillation process", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, vol. 439, no. 1, 1 janvier 2000 (2000-01-01), pages 178-188, XP004253721, ISSN: 0168-9002, DOI: 10.1016/S0168-9002(99)00894-3**
• **SANDERSON ET AL: "Thick source beta counting (TSBC): A rapid method for measuring beta dose-rates", INTERNATIONAL JOURNAL OF RADIATION APPLICATIONS AND INSTRUMENTATION. PART D. NUCLEAR TRACKS AND RADIATION MEASUREMENTS, PERGAMON, vol. 14, no. 1-2, 1 janvier 1988 (1988-01-01), pages 203-207, XP027270974, ISSN: 1359-0189 [extrait le 1988-01-01]**

**Description**

La présente invention s'applique notamment au domaine de la lithographie électronique pour la gravure directe sur wafer ou pour la fabrication de masques. Plus généralement, elle s'applique à tout domaine où on a besoin de modéliser l'interaction d'un faisceau d'électrons avec une cible, ce qui est également le cas en microscopie électronique, notamment pour l'inspection des wafers et des masques. Cette interaction est notamment affectée par une diffusion des électrons autour de la trajectoire initiale (effet de forward scattering ou de diffusion vers l'avant) ainsi que par une rétrodiffusion (effet de back scattering ou de diffusion vers l'arrière). Ces effets, qualifiés d'effets de proximité, dépendent notamment des matériaux de la cible et de sa géométrie. Quelle que soit la raison pour laquelle on souhaite effectuer ce bombardement électronique (gravure, imagerie ou analyse), il est donc nécessaire de tenir compte des effets de proximité pour obtenir un résultat qui soit fidèle à l'objectif recherché. On effectue donc une correction des effets de proximité. Pour cela, il est connu de les prédire par un modèle pour en tenir compte dans le calcul des doses de rayonnement électronique utilisées pour bombarder la cible. Il est connu pour cela d'utiliser une fonction dite de diffusion ou d'étalement de point (ou PSF, point spread function) et l'on réalise une convolution de la PSF avec la géométrie de la cible. Une PSF utilisée communément est une combinaison de gaussiennes, une première gaussienne pour modéliser la diffusion vers l'avant (PSF de la diffusion vers l'avant), et une ou plusieurs gaussiennes supplémentaires pour modéliser la rétrodiffusion (PSF de la rétrodiffusion).

L'équation de la PSF est ainsi traditionnellement représentée par une fonction f(x,y) de la forme suivante :

$$f(\xi) = \frac{1}{\pi(1+\eta)}\left(\frac{1}{\alpha^2}e^{\frac{-\xi^2}{\alpha^2}} + \frac{\eta}{\beta^2}e^{\frac{-\xi^2}{\beta^2}}\right)$$

Avec les notations suivantes :

  ◦ $\alpha$ est la largeur du rayonnement direct;
  ◦ $\beta$ est la largeur de rétrodiffusion ;
  ◦ $\eta$ est le ratio des intensités des rayonnements direct et rétrodiffusé.
  ◦ $\xi$ est la position radiale d'un point

Les valeurs des paramètres $\alpha$, $\beta$ et $\eta$ peuvent être déterminées expérimentalement pour un procédé donné. Ces paramètres sont fonction de la tension d'accélération de la machine et de la cible. Typiquement pour une tension d'accélération de l'ordre de 50KV et une cible de silicium ou de verre (SiO$_2$), $\alpha$ est de l'ordre de 30nm, $\beta$ de l'ordre de 10 $\mu$m et $\eta$ de l'ordre de 0.5. Si on compare cependant la distribution d'énergie autour du point d'impact donnée par une PSF de ce type double gaussienne avec celle produite par une simulation utilisant un modèle de Monte-Carlo, on constate des écarts significatifs. Les simulations de type Monte-Carlo, qualifiées dans la suite de la description de modèle de référence, sont plus proches des résultats expérimentaux mais sont difficilement utilisables en production en raison des longs temps de calcul nécessaire à la simulation. Un indicateur de la qualité d'un modèle sera donc le « fit » entre la PSF utilisée et le modèle de référence, le fit étant mesuré par la somme des écarts quadratiques entre les deux courbes représentant les deux modèles sur une taille d'échantillon de points normalisé.
Il apparaît particulièrement utile de trouver des formes de PSF qui soient plus proches des résultats de simulation et des résultats expérimentaux mais qui soient paramétrables et donc calculables en un temps beaucoup plus court que les simulations de Monte-Carlo.

La présente invention résout le problème posé par les écarts de modélisation des effets de proximité en utilisant une classe de PSF combinant des fonctions lorentziennes avec des fonctions gaussiennes, par exemple une fonction de Voigt, ou des approximations de ces fonctions.

La publication Kirov (« Towards two-dimensional brachytherapy dosimetry using plastic scintillator: localization of the scintillation process", Nuclear Instruments & Methods in Physics Research, vol. 439, n°1, janvier 2000) divulgue l'utilisation de fonctions de Voigt pour réaliser l'analyse de faisceaux Béta projetés sur un tissu et réfléchis par un module de plastique. Cette analyse n'est pas transposable au domaine de la lithographie électronique qui porte sur la projection directe de faisceaux d'électrons avec une intensité de rayonnement inférieure de plusieurs ordres de grandeur à celle des scintillateurs.

A cet effet, l'invention prévoit un procédé de projection d'un faisceau électronique sur un wafer ou un masque, ledit procédé comprenant une étape de correction des effets de diffusion dudit faisceau, ladite étape comprenant une sous-étape de calcul d'une fonction d'étalement de point de la diffusion dudit faisceau, et étant caractérisé en ce que ladite fonction d'étalement de point est une combinaison linéaire de fonctions choisies dans un groupe comprenant au moins une fonction de Voigt (230) et une fonction approchant une fonction de Voigt.

Avantageusement, ladite au moins une fonction approchant une fonction de Voigt est une fonction de Pearson VII.

Avantageusement, ladite combinaison linéaire de fonctions comprend également au moins une fonction gaussienne.

Avantageusement, la sous-étape de calcul d'une fonction d'étalement de point comprend une sous-étape de choix des paramètres desdites fonctions incluses dans la combinaison linéaire et des coefficients de ladite combinaison linéaire, ladite sous-étape de choix utilisant une fonction d'optimisation du fit de la fonction d'étalement de point avec la représentation d'une simulation de Monte-Carlo de la diffusion du rayonnement sur le wafer ou le masque ou des résultats expérimentaux.

Avantageusement, ladite au moins une fonction a un extremum qui n'est pas localisé au centre du faisceau.

Avantageusement, ladite au moins une fonction a un extremum qui est localisé sur un pic de diffusion du faisceau électronique vers l'arrière.

Avantageusement, ladite fonction d'étalement de point est une combinaison linéaire d'au moins autant de fonctions que le rayonnement comprend de pics de diffusion vers l'arrière.

Pour mettre en œuvre le procédé, l'invention prévoit également un programme d'ordinateur comprenant des instructions de code de programme permettant l'exécution du procédé de projection d'un faisceau électronique selon l'invention lorsque le programme est exécuté sur un ordinateur, ledit programme comprenant un module de simulation et/ou correction des effets de diffusion dudit faisceau, ledit module comprenant un sous-module de calcul d'une fonction d'étalement de point de la diffusion dudit faisceau, ledit programme étant caractérisé en ce que ladite fonction d'étalement de point est une combinaison linéaire de fonctions choisies dans un groupe comprenant au moins une fonction de Voigt et une fonction approchant une fonction de Voigt.

L'invention couvre également un système de lithographie électronique comprenant un module de projection d'un faisceau électronique sur un wafer ou un masque et un programme d'ordinateur ayant les caractéristiques définies ci-dessus.

L'invention couvre également un système de simulation d'au moins une étape de lithographie électronique comprenant un module de simulation d'une étape de projection d'un faisceau électronique sur un wafer ou un masque et un programme d'ordinateur ayant les caractéristiques définies ci-dessus.

L'invention couvre également un système de microscopie électronique comprenant un module de projection d'un faisceau électronique sur un wafer ou un masque et un programme d'ordinateur ayant les caractéristiques définies ci-dessus.

Dans un mode de réalisation de l'invention dans lequel on utilise une PSF comprenant une fonction ayant quatre fonctions Voigt, on a pu démontrer une amélioration très importante de l'erreur quadratique résiduelle moyenne qui est inférieure de 88% à celle constatée avec quatre gaussiennes.

En outre, les classes de fonction utilisées dans ce mode de réalisation ayant une expression analytique, elles peuvent facilement être intégrées dans les outils du commerce sans modification importante. La fonction de distribution cumulée étant elle-même analytique, les calculs de convolution qui sont nécessaires à la correction des effets de proximité restent du même ordre de complexité calculatoire que les solutions de l'art antérieur.

L'invention sera mieux comprise, ses différentes caractéristiques et avantages ressortiront de la description qui suit de plusieurs exemples de réalisation et de ses figures annexées dont :

- La figure 1 représente la distribution d'énergie absorbée par une résine selon un modèle de référence ;
- La figure 2 représente une fonction gaussienne, une fonction de Lorentz et une fonction de Voigt ;
- Les figures 3a et 3b représentent la distribution d'énergie absorbée par une résine ou par un masque insolé en extrême UV selon un mode de réalisation de l'invention;
- Les figures 4a à 4f représentent la distribution d'énergie absorbée dans différents scenarios d'utilisation de l'invention.

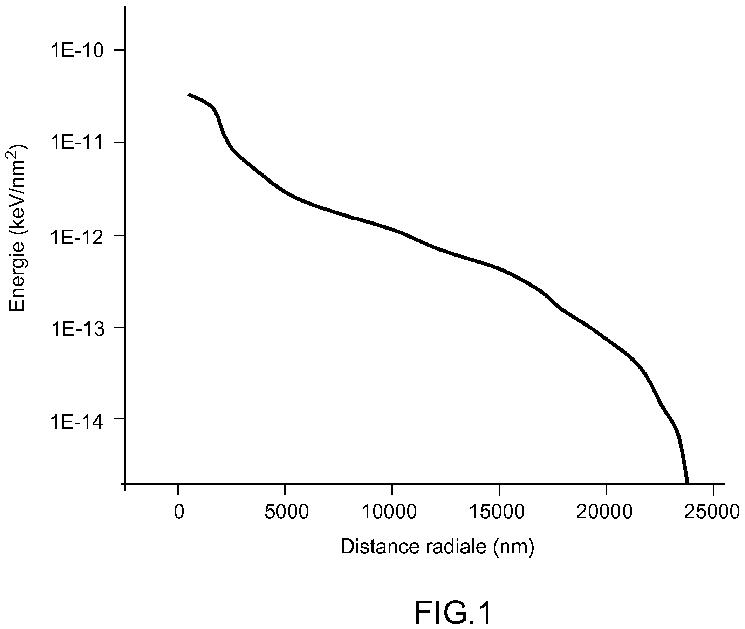

La figure 1 représente la distribution d'énergie absorbée par une résine selon un modèle de référence.

La publication CASINO V2.42 (« A Fast and Easy-to-use Modeling Tool for Scanning Electron Microscopy and Microanalysis Users », Scanning, vol. 29, 92-101 (2007), D. Drouin et alii) expose le fonctionnement d'un logiciel de simulation de la distribution d'énergie d'un faisceau électronique par la méthode de Monte-Carlo. Le logiciel permet de décrire au mieux comment l'énergie se distribue autour du centre du faisceau d'électrons en choisissant les paramètres de différents modèles physiques possibles d'interaction entre les électrons et la cible du faisceau, nature des matériaux et épaisseurs des couches principalement.

Sur l'exemple de la figure, on a représenté la distribution d'énergie absorbée dans 100 nm de PMMA (polyméthacrylate de méthyle) déposé sur un substrat de quartz en fonction de la distance radiale d'un faisceau de 50 keV ($10^6$ électrons), la représentation étant en double échelle logarithmique (log (keV/nm2) en ordonnée et log (nm) en abscisse). On observe que cette distribution ne présente pas de plateaux horizontaux, plateaux obligatoirement présents lors de l'utilisation de fonctions gaussiennes pour décrire cette distribution. Ainsi, l'utilisation de fonctions gaussiennes dans la PSF n'est pas suffisamment précise pour décrire au mieux une distribution d'énergie absorbée de ce type. Comme déjà indiqué, l'objet de l'invention est de prévoir la substitution d'au moins une des fonctions gaussiennes de la PSF par une autre fonction permettant d'obtenir un meilleur fit avec les courbes de distributions du type de celles représentées sur la figure 1 correspondant au modèle de référence.

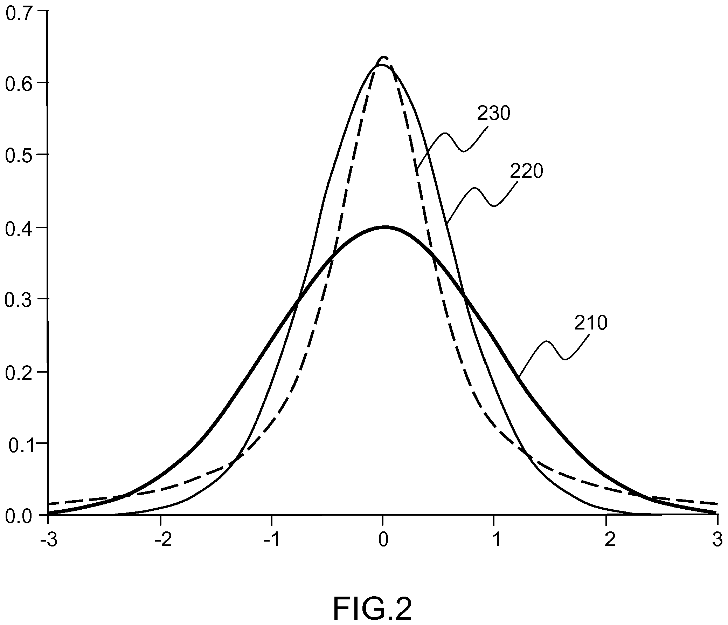

La figure 2 représente une fonction gaussienne, une fonction de Lorentz et une fonction de Voigt ;

Les inventeurs ont montré que les fonctions de types Voigt qui sont le produit de convolution d'une fonction gaussienne et d'une fonction lorentzienne, ou des approximations suffisamment précises de ces fonctions améliorent le fit avec le modèle de référence. Une fonction de Voigt de la distance $\xi$ au centre du faisceau $\xi_c$ se calcule de par la formule de convolution :

$$y(x) = \int_{-\infty}^{+\infty} \left( e^{\left(\frac{(x-t)-x_c}{a}\right)^2} \left( \frac{1}{1+\left(\frac{t-x_c}{b}\right)^2} \right) \right) dt$$

dans laquelle a est l'écart-type de la fonction de Gauss et b est la demi-largeur à mi-hauteur de la fonction de Lorenz, la hauteur étant la valeur de ladite fonction en $x_c$ soit $\frac{1}{\pi}$. Les trois fonctions sont représentées sur la figure : une fonction gaussienne, par la courbe 210, une fonction lorentzienne par la courbe 220 et une fonction de Voigt par la courbe 230. La fonction de Voigt n'étant pas facile à calculer analytiquement, on utilise souvent une approximation par une fonction de Pearson VII qui s'exprime par la formule :

$$y = \frac{1}{\left[ 1 + \left( \frac{2(\xi - \xi_c)\sqrt{2^{\frac{1}{M}} - 1}}{w} \right)^2 \right]^M}$$

dans laquelle M est le paramètre de forme ou largeur de Pearson et w une distance donnant la largeur à la mi-hauteur FWHM (Full Width at Half Maximum) du pic de Pearson. Lorsque M<<1, la forme de la courbe se rapproche d'une courbe de Lorentz.

Lorsque M»10, la forme de la courbe se rapproche d'une courbe de Gauss. Selon l'invention, pour approcher le mieux possible une distribution de rayonnement correspondant à des couches de matériaux spécifiques ayant une épaisseur donnée, on peut combiner de manière linéaire des fonctions de Voigt, des fonctions de Pearson VII, ainsi que des gaussiennes avec soit des fonctions de Voigt ou des fonctions de Pearson VII, les coefficients de la combinaison linéaire et les paramètres desdites fonctions étant judicieusement choisis pour optimiser le fit avec le modèle de référence. Le fit est mesuré par l'erreur quadratique résiduelle moyenne (mean square error). On peut utiliser pour calculer les valeurs des paramètres qui optimisent le fit avec le modèle de référence des méthodes d'optimisation locale par exemple celles basées sur l'algorithme de Levenberg-Marquardt ou l'algorithme du simplexe ou des méthodes d'optimisation plus globale, par exemple le krigeage ou des méthodes basées sur des algorithmes génétiques.

Dans le cas où la part de la rétrodiffusion est importante, notamment pour la gravure de masques en extrême ultraviolet ou la gravure de substrats structurés (comportant localement des différences de compositions, par exemple des zones d'oxydes adjacentes à des zones semi-conductrices), il pourra être envisagé de combiner le procédé de la présente invention avec celui décrit de la demande de brevet française n°11/57338 déposée notamment par un des demandeurs de la présente demande. Selon cette invention, on utilise une PSF qui n'est pas centrée au centre du faisceau.

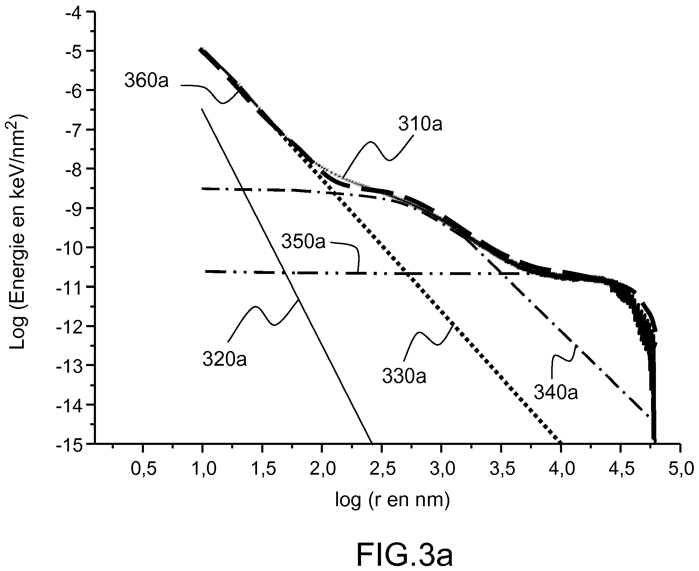

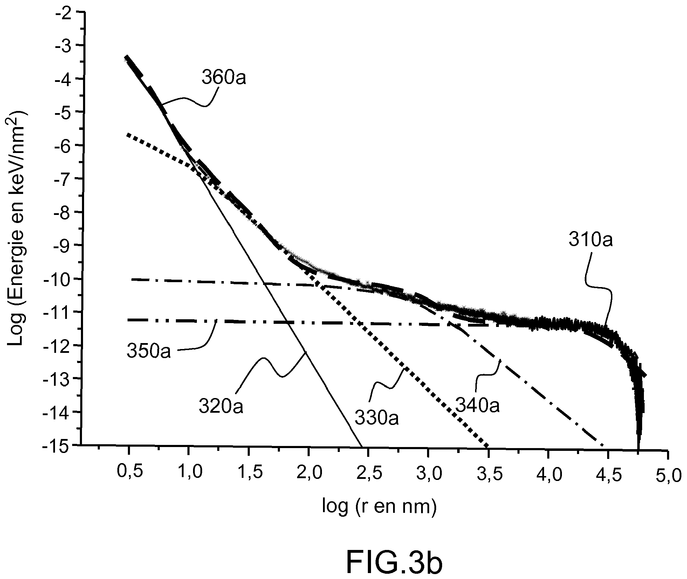

Les figures 3a et 3b représentent la distribution d'énergie absorbée par une résine ou par un masque insolé en extrême UV selon un mode de réalisation de l'invention.

Sur la figure 3a est représenté, à titre purement illustratif et non limitatif de la généralité de l'invention, un mode de réalisation de l'invention dans lequel un masque adapté pour cet usage (c'est-à-dire constitué par exemple d'un support en verre recouvert d'un absorbeur en chrome ou en tantale) est soumis à un rayonnement. Le modèle de référence donné par la courbe 310a est déterminé par le logiciel de simulation CASINO utilisant la base de données ESELPA qui donnent précisément les sections efficaces de collision des électrons avec la matière dans une large gamme d'énergie. Quatre fonctions de Pearson VII sont combinées pour produire la PSF 360a :

- Une première fonction Pearson1 représentée par la courbe 320a, est une fonction de Pearson VII dont les paramètres M et w sont fixés respectivement à 3 et 2,2 nm ;
- Une deuxième fonction Pearson2 représentée par la courbe 330a, est une fonction de Pearson VII dont les paramètres M et w sont fixés respectivement à 1,7 et 8 nm ;
- Une troisième fonction Pearson3 représentée par la courbe 340a, est une fonction de Pearson VII dont les paramètres M et w sont fixés respectivement à 1,5 et 1200 nm ;
- Une quatrième fonction Pearson4 représentée par la courbe 350a, est une fonction de Pearson VII dont les paramètres M et w sont fixés respectivement à 50 et 300 microns.

La PSF est la combinaison linéaire des quatre fonctions de Pearson VII de formule :

$$PSF = Pearson1\,xA1 + Pearson2\,xA2 + Pearson3\,xA3 + Pearson4\,xA4$$

Dans laquelle les coefficients de la combinaison ont les valeurs suivantes :

- A1 tel que log(A1) = -1,25 ;
- A2 tel que log(A2) = -3,7 ;
- A3 tel que log(A3) = - 8,5 ;
- A4 tel que log(A4) = -10.

Sur la figure 3b est représenté, à titre purement illustratif et non limitatif de la généralité de l'invention, un mode de réalisation de l'invention dans lequel un substrat recouvert d'une résine, par exemple en PMMA, est soumis à un rayonnement.
Les représentations et notations sont les mêmes que celles de la figure 3a. Les fonctions de Pearson VII qui sont utilisées sont identiques à celles de la figure 3a. Seuls changent les coefficients Ai de la combinaison linéaire. Ils ont dans ce cas les valeurs suivantes :

- A1 tel que log(A1) = -1,25 ;
- A2 tel que log(A2) = -5,4 ;
- A3 tel que log(A3) = - 10 ;
- A4 tel que log(A4) = -11,2.

Ces valeurs permettent d'obtenir un meilleur fit avec le modèle de référence.

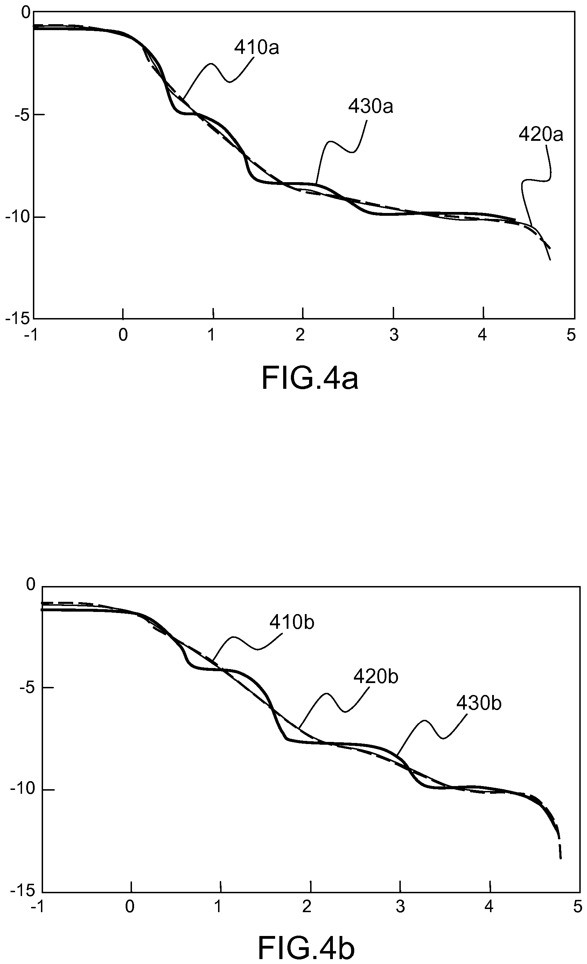

Les figures 4a à 4f représentent la distribution d'énergie absorbée dans différents scenarios d'utilisation de l'invention.
Sur toutes les figures 4a à 4f, on compare la courbe de rayonnement du modèle de référence 410a avec les PSF calculées selon le procédé de l'invention 420a pour la somme de quatre fonctions Voigt et avec celles calculées selon la méthodologie conventionnelle 430a consistant à utiliser une somme de quatre fonctions Gaussiennes.
Sur les figures 4a à 4e, le rayonnement est émis par un petit faisceau (de 2 nm dans l'exemple illustratif de ces figures).
Sur la figure 4a, est illustré un cas dans lequel la cible est un empilement PMMA de 100 nm sur substrat silicium, le rayonnement ayant une énergie de 100 keV.
Sur la figure 4b, est illustré un cas dans lequel la cible est un empilement EUV (extrême UV), le rayonnement ayant une énergie de 100 keV.

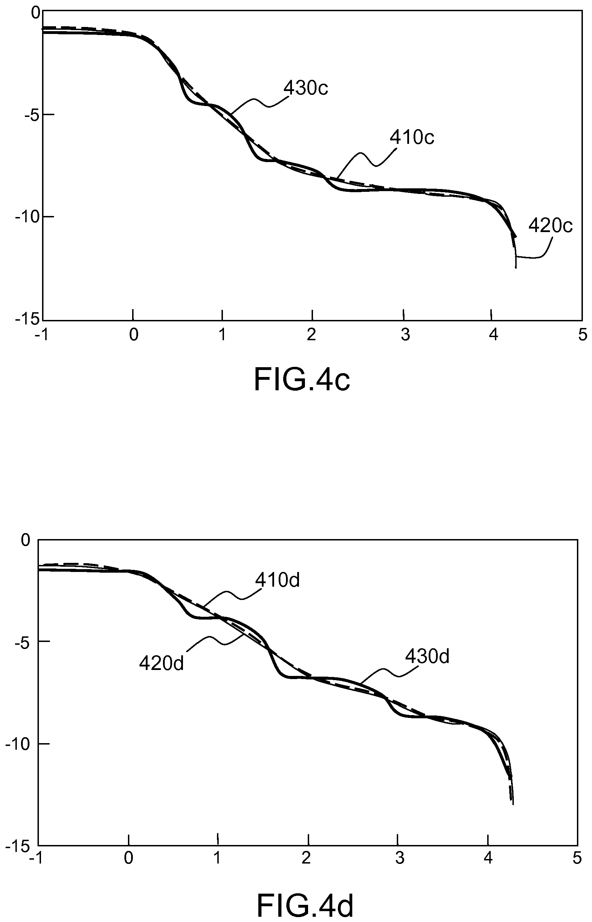

Sur la figure 4c, est illustré un cas dans lequel la cible est un empilement PMMA de 100 nm sur substrat silicium, le rayonnement ayant une énergie de 50 keV.
Sur la figure 4d, est illustré un cas dans lequel la cible est un empilement EUV (extrême UV), le rayonnement ayant une énergie de 50 keV.

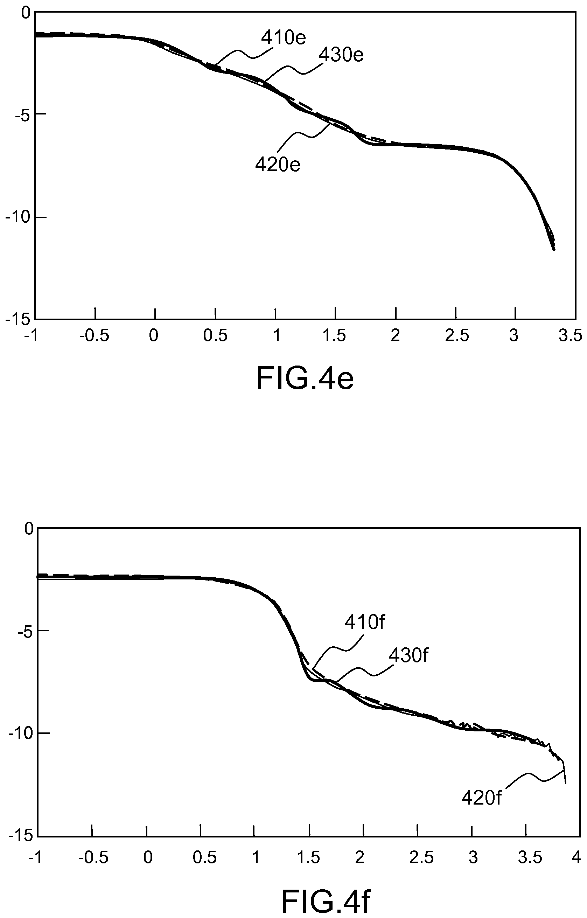

Sur la figure 4e, est illustré un cas dans lequel la cible est un empilement PMMA de 100 nm sur substrat silicium, le rayonnement ayant une énergie de 10 keV.
Sur la figure 4f, est illustré un cas dans lequel la cible est un empilement PMMA de 100 nm sur substrat silicium, le rayonnement étant constitué par un faisceau étendu (30 nm) et ayant une énergie de 100 keV.
Les différentes courbes permettent de constater que le fit entre la PSF de l'invention et le modèle de référence est particulièrement bon dans toutes les configurations illustrées. La qualité du fit du procédé de l'invention ne permet pas de distinguer les courbes 410x de référence des courbes 420x représentatives de l'invention alors que de nets écarts sont observés avec les courbes 430x représentatives de l'art antérieur et utilisant des fonctions gaussiennes.

Le procédé de l'invention peut cependant également être mis en œuvre dans d'autres conditions d'emploi.

Selon l'invention, les fonctions de Voigt ou les fonctions de Pearson VII sont choisies de manière à ce que la distribution résultante soit centrée ou non centrée par rapport au centre du faisceau électronique. Un décentrage de certains pics est envisageable pour des conditions où la retrodiffusion devient prépondérante. De manière privilégiée, le centre de la distribution est ajusté au pic de diffusion vers l'arrière (rétrodiffusion ou backscattering). Ce choix est particulièrement avantageux lorsque l'effet de diffusion vers l'arrière est particulièrement important, notamment lorsque des couches de tantale ou de tantale dopé à l'azote sont implantées sur le substrat comme c'est le cas dans les applications à la fabrication de masques extrême UV. En effet, ces couches de matériaux lourds provoquent une diffusion vers l'arrière très significative. On constate en effet à la fois expérimentalement et par simulation de Monte-Carlo que ledit pic est décentré par rapport au centre du faisceau électronique. Il peut y avoir plusieurs pics de diffusion. Dans ce cas, on choisira avantageusement de combiner autant de fonctions de Voigt ou de Pearson VII que de pics de diffusion. Sur la courbe représentant la distribution d'énergie absorbée, les pics de diffusion peuvent se matérialiser par un changement de pente au niveau de cette courbe. On pourra ainsi choisir avantageusement de combiner autant de fonctions de Voigt ou de Pearson VII que de changement de pente observable. On pourra le cas échéant choisir de centrer au moins une fonction ou chacune sur chaque pic même si cela n'est pas toujours nécessaire pour améliorer le fit.

Pour mettre en œuvre le procédé de l'invention dans ses applications à la lithographie électronique par projection directe sur wafers ou par gravure de masque, on peut utiliser par exemple une machine de type SB 3054 de la société VISTEC™. La modulation de dose peut par exemple être effectuée, selon l'invention, en modifiant un logiciel de modulation de dose, par exemple le logiciel de marque PROXECCO™ distribué par la société Synopsis™ ou le logiciel Inscale™ de la société Aselta Nanographics™ pour remplacer la PSF de la rétrodiffusion de l'art antérieur par la PSF de la rétrodiffusion décrite ci-dessus. Pour la PSF de diffusion vers l'avant, on pourra utiliser comme dans l'art antérieur une gaussienne centrée ou tout autre type de courbe en cloche centrée sur le centre du faisceau.

La modulation de dose est effectuée par convolution de la PSF (PSF de la diffusion vers l'avant et PSF de la rétrodiffusion) avec la géométrie du motif à graver. Le logiciel peut également être avantageusement modifié pour réaliser une optimisation combinée de la modulation de dose et de la géométrie du motif à graver, selon un procédé tel que celui décrit dans la demande internationale PCT/EP2011/05583 licencié à un des déposants de la présente demande.

Le procédé de l'invention et le programme d'ordinateur pour le mettre en œuvre peuvent être également utilisés pour optimiser la PSF de systèmes de microscopie électronique, à balayage, à effet de champ ou à effet tunnel qui peuvent être utilisés en imagerie ou pour réaliser l'inspection de wafers ou de masques. Ils peuvent également être adaptés pour réaliser une simulation d'une ou plusieurs étapes d'un procédé de lithographie électronique.

Les exemples décrits ci-dessus sont donc donnés à titre d'illustration certains de modes de réalisation de l'invention. Ils ne limitent en aucune manière le champ de l'invention qui est défini par les revendications qui suivent.

## Revendications

1. Procédé de projection d'un faisceau électronique sur un wafer ou un masque, ledit procédé comprenant une étape de correction des effets de diffusion dudit faisceau, ladite étape comprenant une sous-étape de calcul d'une fonction d'étalement de point (360a) de la diffusion dudit faisceau, et étant **caractérisé en ce que** ladite fonction d'étalement de point est une combinaison linéaire de fonctions choisies dans un groupe comprenant au moins une fonction de Voigt (230) et une fonction approchant une fonction de Voigt (320a, 330a, 340a, 350a).

2. Procédé de projection selon la revendication 1, **caractérisé en ce que** ladite au moins une fonction approchant une fonction de Voigt est une fonction de Pearson VII.

3. Procédé de projection selon la revendication 1, **caractérisé en ce que** ladite combinaison linéaire de fonctions comprend également au moins une fonction gaussienne (210).

4. Procédé de projection selon l'une des revendications 1 à 3, **caractérisé en ce que** la sous-étape de calcul d'une fonction d'étalement de point comprend une sous-étape de choix des paramètres desdites fonctions incluses dans la combinaisons linéaire et des coefficients de ladite combinaison linéaire , ladite sous-étape de choix utilisant une fonction d'optimisation du fit de la fonction d'étalement de point (360a) avec la représentation (310a) d'une simulation de Monte-Carlo de la diffusion du rayonnement sur le wafer ou le masque ou des résultats expérimentaux.

5. Procédé de projection selon l'une des revendications 1 à 4, **caractérisé en ce que** ladite au moins une fonction a un extremum qui n'est pas localisé au centre du faisceau.

6. Procédé de projection selon la revendication 5, **caractérisé en ce que** ladite au moins une fonction a un extremum qui est localisé sur un pic de diffusion du faisceau électronique vers l'arrière.

7. Procédé de projection selon l'une des revendications précédentes, **caractérisé en ce que** ladite fonction d'étalement de point est une combinaison linéaire d'au moins autant de fonctions que le rayonnement comprend de pics de diffusion vers l'arrière.

8. Programme d'ordinateur comprenant des instructions de code de programme permettant l'exécution du procédé de projection d'un faisceau électronique selon l'une des revendications 1 à 7 lorsque le programme est exécuté sur un ordinateur, ledit programme comprenant un module de simulation et/ou correction des effets de diffusion dudit faisceau, ledit module comprenant un sous-module de calcul d'une fonction d'étalement de point (360a) de la diffusion dudit faisceau, ledit programme étant **caractérisé en ce que** ladite fonction d'étalement de point est une combinaison linéaire de fonctions choisies dans un groupe comprenant au moins une fonction de Voigt et une fonction approchant une fonction de Voigt.

9. Programme d'ordinateur selon la revendication 8, **caractérisé en ce que** ladite au moins une fonction approchant une fonction de Voigt est une fonction de Pearson VII.

10. Programme d'ordinateur selon l'une des revendications 8 à 9, **caractérisé en ce que** ladite combinaison linéaire de fonctions comprend également au moins une fonction gaussienne.

11. Programme d'ordinateur selon l'une des revendications 9 à 10, **caractérisé en ce qu'**il comprend en outre un module de calcul des paramètres desdites fonctions et des coefficients de ladite combinaison linéaire en optimisant le fit de la fonction d'étalement de point avec la représentation d'une simulation de Monte-Carlo de la diffusion du rayonnement sur le wafer ou le masque ou des résultats expérimentaux.

12. Système de lithographie électronique comprenant un module de projection d'un faisceau électronique sur un wafer ou un masque et un programme d'ordinateur selon une des revendications 8 à 11.

13. Système de simulation d'au moins une étape de lithographie électronique comprenant un module de simulation d'une étape de projection d'un faisceau électronique sur un wafer ou un masque et un programme d'ordinateur selon une des revendications 8 à 11.

14. Système de microscopie électronique comprenant un module de projection d'un faisceau électronique sur un wafer ou un masque et un programme d'ordinateur selon une des revendications 8 à 11.

**Patentansprüche**

1. Verfahren zum Projizieren eines Elektronenstrahls auf einen Wafer oder eine Maske, wobei das Verfahren einen Schritt des Korrigierens der Streueffekte des Strahls umfasst, wobei der Schritt einen Unterschritt des Berechnens einer PSF (Punktspreizfunktion) (360a) der Streuung des Strahls umfasst,
**dadurch gekennzeichnet, dass**
es sich bei der PSF um eine lineare Kombination aus Funktionen handelt, die aus der nachfolgenden Gruppe gewählt sind: mindestens eine Voigt-Funktion (230) und eine Annäherung an eine Voigt-Funktion (320a, 330a, 340a, 350a).

2. Verfahren zum Projizieren nach Anspruch 1, **dadurch gekennzeichnet, dass** die mindestens eine Annäherung an eine Voigt-Funktion eine Pearson-VII-Funktion ist.

3. Verfahren zum Projizieren nach Anspruch 1, **dadurch gekennzeichnet, dass** die lineare Kombination der Funktionen ferner mindestens eine Gauß-Funktion (210) umfasst.

4. Verfahren zum Projizieren nach einem der Ansprüche 1 - 3, **dadurch gekennzeichnet, dass** der Unterschritt des Berechnens einer PSF einen Unterschritt des Wählens der Parameter der in der linearen Kombination enthaltenen Funktionen sowie der Koeffizienten der linearen Kombination umfasst, wobei zum Wählen eine Funktion zum Optimieren der Passung der PSF (360a) mit einer Darstellung (310a) einer Monte-Carlo-Simulation der Strahlenstreuung auf dem Wafer oder der Maske oder mit Versuchsergebnissen verwendet wird.

5. Verfahren zum Projizieren nach einem der Ansprüche 1 - 4, **dadurch gekennzeichnet, dass** die mindestens eine Funktion ein Extremum aufweist, das nicht im Mittelpunkt des Strahls lokalisiert ist.

6. Verfahren zum Projizieren nach Anspruch 5, **dadurch gekennzeichnet, dass** die mindestens eine Funktion ein Extremum aufweist, das auf einem Rückstreuungspeak des Elektronenstrahls lokalisiert ist.

7. Verfahren zum Projizieren nach einem der vorstehenden Ansprüche, **dadurch gekennzeichnet, dass** es sich bei der PSF um eine lineare Kombination aus mindestens sovielen Funktionen handelt, wie die Strahlung Rückstreuungspeaks umfasst.

8. Computerprogramm, umfassend Programmcode-Befehle, die bei Ausführung auf einem Computer die Ausführung des Verfahrens nach einem der Ansprüche 1 - 7 ermöglicht, wobei das Programm ein Modul zur Simulation und/oder Korrektur der Streueffekte des Strahls umfasst, wobei das Modul ein Untermodul zur Berechnung einer PSF (360a) der Streuung des Strahls umfasst,
wobei das Programm **dadurch gekennzeichnet ist, dass** es sich bei der PSF um eine lineare Kombination aus Funktionen handelt, die aus der nachfolgenden Gruppe gewählt sind: mindestens eine Voigt-Funktion und eine Annäherung an eine Voigt-Funktion.

9. Computerprogramm nach Anspruch 8, **dadurch gekennzeichnet, dass** die mindestens eine Annäherung an eine Voigt-Funktion eine Pearson-VII-Funktion ist.

10. Computerprogramm nach einem der Ansprüche 8 - 9, **dadurch gekennzeichnet, dass** die lineare Kombination von Funktionen ferner mindestens eine Gauß-Funktion umfasst.

11. Computerprogramm nach einem der Ansprüche 9 - 10, **dadurch gekennzeichnet, dass** es ferner ein Modul zur Berechnung der Parameter der Funktionen und der Koeffizienten der linearen Kombination durch Optimieren der Passung der PSF zur Darstellung einer Monte-Carlo-Simulation der Strahlungsstreuung auf den Wafer oder die Maske oder mit Versuchsergebnissen umfasst.

12. Elektronenlithographiesystem, umfassend ein Modul zum Projizieren eines Elektronenstrahls auf einen Wafer oder eine Maske und ein Computerprogramm nach einem der Ansprüche 8 - 11.

13. System zur Simulation mindestens eines Elektronenlithographieschritts, umfassend ein Modul zum Simulieren eines Schritts des Projizierens eines Elektronenstrahls auf einen Wafer oder eine Maske und ein Computerprogramm nach einem der Ansprüche 8 - 11.

14. Elektronenmikroskopiesystem, umfassend ein Modul zum Projizieren eines Elektronenstrahls auf einen Wafer oder eine Maske und ein Computerprogramm nach einem der Ansprüche 8 - 11.

## Claims

1. A method for projecting an electron beam onto a wafer or a mask, said method comprising a step of correcting the scattering effects in said beam, said step comprising a sub-step of calculating a point spread function (360a) of the scattering of said beam, and being **characterized in that** said point spread function is a linear combination of functions chosen from a group comprising at least one Voigt function (230) and a function approximating a Voigt function (320a, 330a, 340a, 350a).

2. The projection method of claim 1, wherein said at least one function approximating a Voigt function is a Pearson VII function.

3. The projection method of claim 1, wherein said linear combination of functions also comprises at least one Gaussian function (210).

4. The projection method of anyone of claims 1 to 3, wherein the sub-step of calculating a point spread function comprises a sub-step of selection of the parameters of said functions which are included in the linear combination, and of the coefficients of said linear combination, said selection sub-step comprising an execution of an optimization function of the fit of the point spread function (360a) with a representation (310a) of a Monte-Carlo simulation of the scattering of the radiation on the wafer or the mask or with a set of experimental results.

5. The projection method of anyone of claims 1 to 4, wherein said at least one function has an extremum which is not located at the center of the beam.

6. The projection method of claim 5, wherein said at least one function has an extremum which is located on a backward scattering peak of the electron beam.

7. The projection method of anyone of the preceding claims, **characterized in that** said point spread function is a linear combination of at least as many functions as the radiation comprises backward scattering peaks.

8. A computer program comprising program code instructions configured for the execution of a method for projecting an electron beam of anyone of claims 1 to 7 when the program is executed on a computer, said program comprising a module for simulating and/or correcting the scattering effects in said beam, said module comprising a submodule for calculating a point spread function (360a) of the scattering of said beam,
said program being **characterized in that** said point spread function is a linear combination of functions chosen from a group comprising at least one Voigt function and a function approximating a Voigt function.

9. The computer program of claim 8, wherein said at least one function approximating a Voigt function is a Pearson VII function.

10. The computer program of anyone of claims 8 to 9, wherein said linear combination of functions also comprises at least one Gaussian function.

11. The computer program of anyone of claims claim 9 to 10, further comprising a module for calculating the parameters of said functions and the coefficients of said linear combination by optimizing the fit of the point spread function or with a representation of a Monte-Carlo simulation of the scattering of the radiation on a wafer or a mask or with a set of experimental results.

12. An electron lithography system comprising a module for projecting an electron beam onto a wafer or a mask and a computer program according to claims 8 to 11.

13. A system for simulating at least one electron lithography step comprising a module for simulating a step of projecting an electron beam onto a wafer or a mask and a computer program according to anyone of claims 8 to 11.

14. An electron microscopy system comprising a module for projecting an electron beam onto a wafer or a mask and a computer program of claims 8 to 11.

FIG.1

FIG.2

FIG.3a

FIG.3b

EP 2 650 902 B1

FIG.4a

FIG.4b

FIG.4c

FIG.4d

FIG.4e

FIG.4f

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1157338

- EP 201105583 W

**Littérature non-brevet citée dans la description**

- **KIROV.** Towards two-dimensional brachytherapy dosimetry using plastic scintillator: localization of the scintillation process. *Nuclear Instruments & Methods in Physics Research,* Janvier 2000, vol. 439 (1

- **D. DROUIN ; ALII.** A Fast and Easy-to-use Modeling Tool for Scanning Electron Microscopy and Microanalysis Users. *Scanning,* 2007, vol. 29, 92-101